# EUROPEAN PATENT APPLICATION

(11) **EP 3 675 610 A1**
(43) Date of publication of application: **01.07.2020**
(21) Application number: 17928744.6
(22) Date of filing: 21.12.2017
(51) Int. Cl.: H05K 5/02

(54) **HIGH STRENGTH FINGERPRINT-PROOF GLASS AND PREPARATION METHOD THEREFOR, AND EXTERIOR MEMBER OF HIGH STRENGTH FINGERPRINT-PROOF GLASS AND PREPARATION METHOD THEREFOR**

(30) Priority: 13.10.2017 CN 201710950164
(71) Applicant: Huawei Technologies Co., Ltd., Longgang District Shenzhen, Guangdong 518129 (CN)
(72) Inventor: KIM, Joon Suh, Shenzhen Guangdong 518129 (CN); XU, Ting, Shenzhen Guangdong 518129 (CN); LI, Qingmeng, Shenzhen Guangdong 518129 (CN); XU, Yanxiang, Shenzhen Guangdong 518129 (CN)
(74) Representative: Grünecker Patent- und Rechtsanwälte PartG mbB
(86) International application number: PCT/CN2017/117801
(87) International publication number: WO 2019/071835

(57) **Abstract**

High-strength anti-fingerprint glass is provided, including a glass base material. The glass base material includes a first surface and a second surface that are provided opposite to each other, at least one of the first surface and the second surface is provided with a micro-texture structure, the micro-texture structure includes a plurality of micro-texture units, an orthographic projection area of each micro-texture unit on the first surface or the second surface ranges from 0.0004 mm² to 0.0144 mm², and a maximum distance between the micro-texture unit and the surface on which the micro-texture unit is located ranges from 2 µm to 7 µm. For the high-strength anti-fingerprint glass, a physical structure of a glass surface is changed due to setting of the micro-texture structure on the surface, thereby helping to fundamentally resolve a problem that a fingerprint and an oil stain are easily generated on the glass surface, and greatly improving anti-impact strength of the glass.

## Description

### TECHNICAL FIELD

Embodiments of the present invention relate to the field of glass surface processing technologies, and in particular, to high-strength anti-fingerprint glass, a preparation method thereof, an exterior part of the anti-fingerprint glass, and a preparation method thereof.

### BACKGROUND

Currently, glass is commonly applied to communications electronic products such as a mobile phone. For example, the glass is used as a touchscreen cover and a rear cover of the mobile phone. However, the glass is often in direct contact with a fingerprint of a user, or an oil stain is generated on a surface due to environmental pollution, and after the glass is wiped, clear fog-like wiping traces still remain on the surface, thereby affecting user experience.

To improve this problem, currently, anti-fingerprint coating (Anti-finger coating) is often performed by using a coating that contains an active silane group and a fluorine-modified organic group. However, anti-fingerprint coating only enables a fingerprint, an oil stain, and the like that are generated on the surface of the glass to be relatively easily wiped, and a problem that fingerprints and smudginess are easily and frequently generated because a finger directly comes into contact with the surface of the glass is not fundamentally resolved.

### SUMMARY

In view of this, an embodiment of the present invention provides high-strength anti-fingerprint glass, and a micro-texture structure is provided on a surface of the anti-fingerprint glass. Setting of the micro-texture structure can change a physical structure of the glass surface, thereby helping to fundamentally resolve a problem that a fingerprint and an oil stain are easily generated on the glass surface.

Specifically, according to a first aspect, an embodiment of the present invention provides high-strength anti-fingerprint glass, including a glass base material, where the glass base material includes a first surface and a second surface that are provided opposite to each other, at least one of the first surface and the second surface is provided with a micro-texture structure, the micro-texture structure includes a plurality of micro-texture units, an orthographic projection area of each micro-texture unit on the first surface or the second surface ranges from 0.0004 mm² to 0.0144 mm², and a maximum distance between the micro-texture unit and the surface on which the micro-texture unit is located ranges from 2 µm to 7 µm.

A visible light transmittance of the high-strength anti-fingerprint glass is 95% to 100%.

A spacing between any two adjacent micro-texture units is 0.02 mm to 0.2 mm.

Specifically, the plurality of micro-texture units are regularly or irregularly arranged on the glass base material. The plurality of micro-texture units bestrew the first surface or the second surface.

The micro-texture unit is a three-dimensional pattern, and is specifically a groove or a protrusion of a geometric or non-geometric shape.

In an implementation of the present invention, the plurality of micro-texture units are of the same shapes, have the same orthographic projection areas on the first surface or the second surface, and are arranged on the glass base material in arrays.

In an implementation of the present invention, a local area or all areas of the at least one of the first surface and the second surface are set as texture gradient areas. In a direction in the texture gradient area, an orthographic projection area of the micro-texture unit on the first surface or the second surface gradually decreases, and a spacing between two adjacent micro-texture units gradually increases.

A thickness of the high-strength anti-fingerprint glass is 0.5 mm to 0.7 mm, hardness is 650 HV to 700 HV, and anti-impact strength is 0.5 joules/m² to 1.25 joules/m².

In this embodiment of the present invention, the high-strength anti-fingerprint glass is 2D glass, 2.5D glass, or 3D glass.

A surface of the high-strength anti-fingerprint glass provided according to the first aspect of this embodiment of the present invention is provided with a micro-texture structure invisible to a naked eye, and the micro-texture structure changes a physical structure of the glass surface, so as to fundamentally prevent generation of a fingerprint and an oil stain on the glass surface. In addition, in this embodiment of the present invention, a size of the micro-texture unit is properly designed, so that the glass not only has a good anti-fingerprint effect, but also has high light transmittance and anti-impact strength.

Correspondingly, according to a second aspect, an embodiment of the present invention provides a method for preparing high-strength anti-fingerprint glass, including the following steps:
obtaining a white glass raw material, where the white glass raw material includes a first surface and a second surface that are provided opposite to each other; and performing etching on at least one of the first surface and the second surface of the white glass raw material by using a photochemical etching (photochemical etching) method to form a micro-texture structure, to obtain 2D high-strength anti-fingerprint glass; or
obtaining a white glass raw material; first processing the white glass raw material into a 2.5D shape; and then performing etching on at least one of a first surface and a second surface of the white glass raw material by using a photochemical etching method to form a micro-texture structure, to obtain 2.5D high-strength anti-fingerprint glass; or
obtaining a white glass raw material; first processing the white glass raw material into a 3D shape; and then performing etching on at least one of a first surface and a second surface of the white glass raw material by using a photochemical etching method, to form a micro-texture structure; or first performing etching on at least one of a first surface and a second surface of the white glass raw material by using a photochemical etching method, to form a micro-texture structure, and then processing the white glass raw material with the micro-texture structure into a 3D shape, to obtain 3D high-strength anti-fingerprint glass, where
the micro-texture structure includes a plurality of micro-texture units, an orthographic projection area of each micro-texture unit on the first surface or the second surface ranges from 0.0004 mm² to 0.0144 mm², and a maximum distance between the micro-texture unit and the surface on which the micro-texture unit is located ranges from 2 µm to 7 µm.
specific operations of the photochemical etching method are as follows: cleaning a to-be-etched white glass raw material, coating the white glass raw material with a layer of photoresist after the white glass raw material is dried, exposing a to-be-etched area to the outside after exposure and development, and placing the white glass raw material into an etching solution, and after the white glass raw material is etched for 2 to 10 seconds, taking the white glass raw material out and removing a film, to obtain a micro-texture structure, where the etching solution includes hydrogen fluoride and/or another weak acid substance. The to-be-etched area comes into contact with the etching solution during etching, so as to achieve a dissolution and corrosion effect, to form a concave-convex or hollow effect, for example, etching is performed to form various patterns, designs, scales, and lattices.

In the method for preparing high-strength anti-fingerprint glass provided according to the second aspect of the embodiment of the present invention, a process is simple, thereby facilitating scale production.

According to a third aspect, an embodiment of the present invention further provides an exterior part of high-strength anti-fingerprint glass, including a glass exterior part matrix and an anti-fingerprint protective film disposed on a surface of the glass exterior part matrix, where the glass exterior part matrix is made of the high-strength anti-fingerprint glass according to the first aspect of the embodiment of the present invention.

The glass exterior part matrix may be any glass product, and may be specifically a terminal housing, a terminal cover, a key, a touchscreen, meter glass, or a camera protection cover.

The glass exterior part matrix includes a first surface and a second surface that are provided opposite to each other; an edge area of at least one of the first surface and the second surface is set as a texture gradient area, and a width of the texture gradient area is 2 mm to 10 mm; and from an inner circumference to an outer circumference in the texture gradient area, an orthographic projection area of the micro-texture unit on the first surface or the second surface gradually decreases, and a spacing between the two adjacent micro-texture units gradually increases.

A surface of the exterior part of the high-strength anti-fingerprint glass provided in this embodiment of the present invention is provided with a micro-texture structure. Setting of the micro-texture structure changes a physical structure of the glass surface, so that a contact area between the glass surface and a finger of a user can be changed, and generation of a fingerprint and an oil stain on the glass surface is fundamentally resolved by combining with an anti-fingerprint coating. In addition, the exterior part of the high-strength anti-fingerprint glass provided in this embodiment of the present invention has high light transmittance and anti-impact strength.

According to a fourth aspect, an embodiment of the present invention further provides a method for preparing an exterior part of high-strength anti-fingerprint glass, including the following steps:
obtaining a white glass raw material, where the white glass raw material includes a first surface and a second surface that are provided opposite to each other; cutting and performing CNC (computer numerical control, Computer numerical control) processing on the white glass raw material to meet an exterior part design requirement; then performing etching on at least one of the first surface and the second surface of the white glass raw material by using a photochemical etching method, to form a micro-texture structure; and then performing anti-fingerprint coating to obtain the exterior part of the high-strength anti-fingerprint glass, where a CNC process enables the glass to remain a 2D shape or to form a 2.5D shape; or
obtaining a white glass raw material; processing the white glass raw material to meet an exterior part design requirement by successively performing a cutting, CNC, hot bending, and polishing process; performing etching on at least one of a first surface and a second surface of the white glass raw material by using a photochemical etching method, to form a micro-texture structure; and then performing anti-fingerprint coating to obtain the exterior part of the high-strength anti-fingerprint glass, where a 3D shape is formed in the hot bending process; or
obtaining a white glass raw material; after cutting, performing etching on at least one of a first surface and a second surface of the white glass raw material by using a photochemical etching method, to form a micro-texture structure; processing the white glass raw material to meet an exterior part design requirement by successively performing CNC and hot bending; and then performing anti-fingerprint coating to obtain the exterior part of the high-strength anti-fingerprint glass, where a 3D shape is formed in the hot bending process, where
the micro-texture structure includes a plurality of micro-texture units, an orthographic projection area of each micro-texture unit on the first surface or the second surface ranges from 0.0004 mm² to 0.0144 mm², and a maximum distance between the micro-texture unit and the surface on which the micro-texture unit is located ranges from 2 µm to 7 µm.

In the method for preparing the exterior part of the high-strength anti-fingerprint glass provided in this embodiment of the present invention, a process is simple, thereby facilitating scale production.

Advantages of the embodiments of the present invention are partially described in the following specification. Some advantages are clear according to this specification, or may be learned through implementation of the embodiments of the present invention.

### BRIEF DESCRIPTION OF DRAWINGS

FIG 1 is a schematic structural diagram of an existing mobile phone that uses a glass touchscreen;
FIG 2 is a schematic diagram of a fingerprint residue caused by finger of a user coming into contact with a glass touchscreen;
FIG 3 is a schematic structural diagram of a rear glass cover of the mobile phone according to Embodiment 1 of the present invention;
FIG 4 is a schematic diagram of a local cross section of a rear glass cover of the mobile phone according to Embodiment 1 of the present invention;
FIG. 5 is a scanning electron microscope diagram of an arc edge of a rear glass cover of a mobile phone before etching according to Embodiment 1 of the present invention;
FIG. 6 is a scanning electron microscope diagram of an arc edge of a rear glass cover of a mobile phone after etching according to Embodiment 1 of the present invention;
FIG. 7 is a schematic structural diagram of a rear glass cover of a mobile phone according to Embodiment 2 of the present invention.

### DESCRIPTION OF EMBODIMENTS

The following descriptions are preferred implementations of embodiments of the present invention. It should be noted that a person of ordinary skill in the art may make improvements and polishing without departing from the principle of the embodiments of the present invention, and the improvements and polishing shall fall within the protection scope of the embodiments of the present invention.

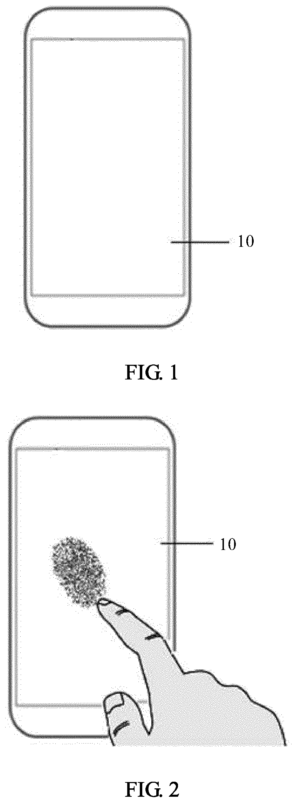

Currently, glass is commonly applied to communications electronic products such as a mobile phone. For example, the glass is used as a touchscreen cover (as shown in 10 in FIG. 1) and a rear cover of the mobile phone. However, as shown in FIG. 2, when a finger of a user directly comes into contact with the glass, a fingerprint of the user are usually left on a glass surface, or an oil stain is generated on the glass surface due to environmental pollution, and after the glass is wiped, clear fog-like wiping traces still remain on the glass surface, thereby affecting user experience. To resolve a problem of a fingerprint residue on the existing glass surface, an anti-fingerprint coating is usually provided on the glass surface in the industry. In this method, although a fingerprint residue problem is alleviated to an extent, the anti-fingerprint coating only enables the fingerprint, an oil stain, and the like that are generated on the glass surface to be relatively easily wiped, and a problem that fingerprints and smudginess are easily and frequently generated because a finger directly comes into contact with the glass surface is not fundamentally resolved.

Thereby, to fundamentally resolve the problem of the fingerprint residue on the existing glass surface and improve user experience, an embodiment of the present invention provides high-strength anti-fingerprint glass, including a glass base material. The glass base material includes a first surface and a second surface that are provided opposite to each other, and at least one of the first surface and the second surface is provided with a micro-texture structure. The micro-texture structure includes a plurality of micro-texture units, an orthographic projection area of each micro-texture unit on the first surface or the second surface ranges from 0.0004 mm² to 0.0144 mm², and a maximum distance between the micro-texture unit and the surface on which the micro-texture unit is located ranges from 2 µm to 7 µm.

In this embodiment of the present invention, the micro-texture structure is a micro mechanism structure that is invisible to a naked eye. In this embodiment of the present invention, a size of the micro-texture unit is properly designed, so that when a good anti-fingerprint effect is obtained, the glass still maintains good light transmittance, and obtains higher anti-impact strength than glass whose micro-texture structure is not etched.

In this embodiment of the present invention, an orthographic projection area of each micro-texture unit on the first surface or the second surface may be further 0.0007 mm² to 0.0064 mm², 0.001 mm² to 0.005 mm², or 0.002 mm² to 0.004 mm². A maximum distance between the micro-texture unit and the surface on which the micro-texture unit is located is 2 µm to 7 µm, and may be specifically 2 µm, 3 µm, 4 µm, 5 µm, 6 µm, 7 µm. That is, if the micro-texture unit is provided on the first surface, the maximum distance is a maximum distance between the micro-texture unit and the first surface.

Specifically, in an implementation of the present invention, visible light transmittance of the high-strength anti-fingerprint glass is 95% to 100%. The visible light transmittance of the high-strength anti-fingerprint glass in this embodiment of the present invention is basically equivalent to that of white glass, and setting of the micro-texture structure does not reduce the visible light transmittance of the glass.

Specifically, in an implementation of the present invention, a thickness of the high-strength anti-fingerprint glass is 0.5 mm to 0.7 mm, hardness is 650 HV to 700 HV, and anti-impact strength is 0.5 joules/m² to 1.25 joules/m². The anti-impact strength is increased by 150% to 210% compared with white glass whose micro-texture structure having the same thickness is not etched.

In an implementation of the present invention, a spacing between any two adjacent micro-texture units is 0.02 mm to 0.2 mm, for example, may be 0.02 mm, 0.05 mm, 0.08 mm, 0.1 mm, 0.12 mm, 0.15 mm, 0.18 mm, or 0.2 mm. The spacing between the micro-texture units directly affects adhesion of a fingerprint and smudginess. Setting the spacing to a smaller size can improve anti-fingerprint and anti-oil stain performance of the glass, and glass with a larger spacing is closer to the common white glass.

In an implementation of the present invention, the plurality of micro-texture units are regularly or irregularly arranged on the glass base material. A regular arrangement may be an arrangement in arrays. The plurality of micro-texture units bestrew the first surface or the second surface.

In an implementation of the present invention, a specific design shape of the micro-texture unit is not specifically limited. The micro-texture unit is a three-dimensional pattern, and may be specifically a groove or a protrusion of a geometric or non-geometric shape. The geometric shape may be a non-linear structure, for example, may be a spherical, semi-spherical, square (such as quadrate), rhombic, polygonal, or pentagram shape, or may be a linear structure, that is, a line-type groove or protrusion, including a straight line type or a curve type. The non-geometric shape may be a character or a pattern such as a snowflake shape or a flower shape.

In a specific implementation of the present invention, the micro-texture structure is a protrusion in arrays. In another specific implementation of the present invention, the micro-texture structure is a groove in arrays. A specific shape of the protrusion or groove in arrays may be a spherical, semi-spherical, square, rhombic, polygonal, pentagram shape, or the like.

In an implementation of the present invention, the plurality of micro-texture units are of the same shapes, have the same orthographic projection areas on the first surface or the second surface, and are arranged on the glass base material in arrays.

In another implementation of the present invention, a local area or all areas of the at least one of the first surface and the second surface are set as texture gradient areas. A location of the texture gradient area and a texture gradient trend may be designed based on a specific requirement. For example, in a direction in the texture gradient area, the orthographic projection area of the micro-texture unit on the first surface or the second surface gradually decreases, and a spacing between two adjacent micro-texture units gradually increases. The texture gradient design can improve an appearance, a hand feeling, and local performance of the product.

In an implementation of the present invention, the high-strength anti-fingerprint glass may be 2D glass, 2.5D glass, or 3D glass.

Correspondingly, an embodiment of the present invention provides a method for preparing high-strength anti-fingerprint glass, including the following steps:
obtaining a white glass raw material, where the white glass raw material includes a first surface and a second surface that are provided opposite to each other; and performing etching on at least one of the first surface and the second surface of the white glass raw material by using a photochemical etching method to form a micro-texture structure, to obtain 2D high-strength anti-fingerprint glass; or
obtaining a white glass raw material; first processing the white glass raw material into a 2.5D shape; and then performing etching on at least one of a first surface and a second surface of the white glass raw material by using a photochemical etching method to form a micro-texture structure, to obtain 2.5D high-strength anti-fingerprint glass; or
obtaining a white glass raw material; first processing the white glass raw material into a 3D shape; and then performing etching on at least one of a first surface and a second surface of the white glass raw material by using a photochemical etching method, to form a micro-texture structure; or first performing etching on at least one of a first surface and a second surface of the white glass raw material by using a photochemical etching method, to form a micro-texture structure, and then processing the white glass raw material with the micro-texture structure into a 3D shape, to obtain 3D high-strength anti-fingerprint glass, where
the micro-texture structure includes a plurality of micro-texture units, an orthographic area of each micro-texture unit on the first surface or the second surface ranges from 0.0004 mm² to 0.0144 mm², and a maximum distance between the micro-texture unit and the surface on which the micro-texture unit is located ranges from 2 µm to 7 µm.

In the foregoing preparation method in this embodiment of the present invention, specific operations of the photochemical etching method are as follows: cleaning a to-be-etched white glass raw material, coating the white glass raw material with a layer of photoresist after the white glass raw material is dried, exposing a to-be-etched area to the outside after exposure and development, and placing the white glass raw material into an etching solution, and after the white glass raw material is etched for 2 to 10 seconds, taking the white glass raw material out and removing a film, to obtain a micro-texture structure, where the etching solution includes hydrogen fluoride and/or another weak acid substance. The to-be-etched area comes into contact with the etching solution during etching, so as to achieve a dissolution and corrosion effect, to form a concave-convex or hollow effect, for example, etching is performed to form various patterns, designs, scales, and lattices. Optionally, the etching time is 2 to 4 seconds or 5 to 8 seconds. A mass concentration of hydrogen fluoride in the etching solution is 20% to 40%, or even 30% to 40%, or 25% to 35%. The photoresist may be of an existing common photoresist type.

In an implementation of the present invention, the white glass raw material may be processed into a 2.5D shape or a 3D shape by using an existing common operation. For example, the white glass raw material is processed into a 2.5D shape by using a CNC process, or the white glass raw material is processed into a 3D shape by using a 3D glass hot bending machine and by using a hot bending operation.

In an implementation of the present invention, the preparation method further includes toughening processing. The toughening processing can enhance hardness and abrasion resistance of the glass.

An embodiment of the present invention further provides an exterior part of high-strength anti-fingerprint glass, including a glass exterior part matrix and an anti-fingerprint protective film disposed on a surface of the glass exterior part matrix. The glass exterior part matrix is made of the high-strength anti-fingerprint glass according to the foregoing embodiment of the present invention.

In an implementation of the present invention, the glass exterior part matrix may be any glass product, and may be specifically a terminal housing, a terminal cover, a key, a touchscreen, meter glass, or a camera protection cover.

The exterior part of the high-strength anti-fingerprint glass in this embodiment of the present invention is based on a feature of the foregoing high-strength anti-fingerprint glass, and details are not described herein again.

In an implementation of the present invention, the glass exterior part matrix includes a first surface and a second surface that are provided opposite to each other. A local area or all areas of at least one of the first surface and the second surface of the glass exterior part matrix are set as texture gradient areas. In a specific implementation of the present invention, a peripheral edge area of at least one of the first surface and the second surface of the glass exterior part matrix is set as a texture gradient area, and a width of the texture gradient area is 2 mm to 10 mm; and from an inner circumference to an outer circumference in the texture gradient area, an orthographic projection area of a micro-texture unit on the first surface or the second surface gradually decreases, and a spacing between two adjacent micro-texture units gradually increases. For example, the glass exterior part matrix is a 3D glass or 2.5D glass rear cover of a mobile phone, and a width of a peripheral arc edge of the 3D glass or the 2.5D glass is 2 mm to 10 mm; the arc edge is set as a texture gradient area; from an inner circumference to an outer circumference of the arc edge, an orthographic projection area of the micro-texture unit on the first surface or the second surface gradually decreases, and a spacing between two adjacent micro-texture units gradually increases. Such a texture gradient design enables light shadows to be suitable for radians of internal and external surfaces of the 3D or 2.5D glass. In combination with the light shadows of the texture gradient area, product appearance integrity is improved, a hand feeling during holding is improved, and user experience is enhanced.

In an implementation of the present invention, a material of the anti-fingerprint protective film may be fluoride, and a thickness of the film is less than 0.1 µm. Specifically, the anti-fingerprint protective film may be a coating formed by a fluorine-containing coating. The fluorine-containing coating specifically includes a fluorosilicone resin that includes an active silane group and a fluorine-modified organic group. Combination of the anti-fingerprint protective film and the micro-texture structure can better achieve a fingerprint removal effect. There is no conflict between the two processes. In addition, because of existence of the micro-texture structure on the glass surface, the anti-fingerprint protective film is more tightly bonded with the glass surface.

Correspondingly, an embodiment of the present invention provides a method for preparing an exterior part of high-strength anti-fingerprint glass, including the following steps:
obtaining a white glass raw material, where the white glass raw material includes a first surface and a second surface that are provided opposite to each other; cutting and performing CNC processing on the white glass raw material to meet an exterior part design requirement; then performing etching on at least one of the first surface and the second surface of the white glass raw material by using a photochemical etching method, to form a micro-texture structure; and then performing anti-fingerprint coating to obtain the exterior part of high-strength anti-fingerprint glass, where a CNC process enables the glass to remain a 2D shape or to form a 2.5D shape; or
obtaining a white glass raw material; processing the white glass raw material to meet an exterior part design requirement by successively performing a cutting, CNC, hot bending, and polishing process; performing etching on at least one of a first surface and a second surface of the white glass raw material by using a photochemical etching method, to form a micro-texture structure; and then performing anti-fingerprint coating to obtain the exterior part of high-strength anti-fingerprint glass, where a 3D shape is formed in the hot bending process; or
obtaining a white glass raw material; after cutting, performing etching on at least one of a first surface and a second surface of the white glass raw material by using a photochemical etching method, to form a micro-texture structure; processing the white glass raw material to meet an exterior part design requirement by successively performing CNC and hot bending; and then performing anti-fingerprint coating to obtain the exterior part of high-strength anti-fingerprint glass, where a 3D shape is formed in the hot bending process, where
the micro-texture structure includes a plurality of micro-texture units, an orthographic projection area of each micro-texture unit on the first surface or the second surface ranges from 0.0004 mm² to 0.0144 mm², and a maximum distance between the micro-texture unit and the surface on which the micro-texture unit is located ranges from 2 µm to 7 µm
specific operations of the photochemical etching method are as follows: cleaning a to-be-etched white glass raw material, coating the white glass raw material with a layer of photoresist after the white glass raw material is dried, exposing a to-be-etched area to the outside after exposure and development, and placing the white glass raw material into an etching solution, and after the white glass raw material is etched for 2 to 10 seconds, taking the white glass raw material out and removing a film, to obtain a micro-texture structure, where the etching solution includes hydrogen fluoride and/or another weak acid substance. The to-be-etched area comes into contact with the etching solution during etching, so as to achieve a dissolution and corrosion effect, to form a concave-convex or hollow effect, for example, etching is performed to form various patterns, designs, scales, and lattices. Optionally, the etching time is 2 to 4 seconds or 5 to 8 seconds. A mass concentration of hydrogen fluoride in the etching solution is 20% to 40%, or even 30% to 40%, or 25% to 35%.

In an implementation of the present invention, the preparation method further includes toughening processing. The toughening processing can enhance hardness and abrasion resistance of the glass.

In an implementation of the present invention, the cutting, CNC, hot bending, and polishing process may all be performed in an existing commonly used operation manner. This is not specifically limited in the present invention. In the CNC process, various fine structures may be obtained through processing based on use and a model requirement of a specific pre-prepared exterior part. The hot bending process is completed by using a hot bending machine. In an implementation of the present invention, a conventional process step may also be added based on actual requirement. For example, a CNC operation or a polishing operation is added once.

In an implementation of the present invention, anti-fingerprint coating (Anti-finger coating) may be performed by using an existing operation. Specifically, a surface of a glass exterior part is coated with or infiltrated into a commercially available AF anti-fingerprint medicine liquid, or vacuum evaporation is performed on a commercially available AF anti-fingerprint pellet to form an anti-fingerprint protective film. The commercially available AF anti-fingerprint medicine liquid usually includes two parts: an AF main agent and a diluent. The main agent is mainly a perfluoropolyether polymer. A component of the commercially available AF anti-fingerprint pellet is the AF main agent.

In an implementation of the present invention, before or after the anti-fingerprint coating, another coating operation may also be performed, so as to improve performance of an exterior part in another aspect.

The following further describes the embodiments of the present invention by using a rear cover of a mobile phone as an example.

### Embodiment 1

A high-strength anti-fingerprint glass rear cover of a mobile phone includes a rear cover matrix (2.5D glass) of the mobile phone. The rear cover matrix of the mobile phone includes a first surface and a second surface that are provided opposite to each other, and a micro-texture structure is provided on the first surface, and an anti-fingerprint protective film is further disposed. In this embodiment, the first surface is a side surface that a user can directly come into contact with and that faces the outside of the mobile phone. The micro-texture structure includes a plurality of semi-spherical protrusions.

In an intermediate plane area of the rear cover matrix of the mobile phone, the semi-spherical protrusion are arranged in arrays with a diameter of approximately 0.09 mm, an orthographic projection area on the first surface is 0.0064 mm², a spacing between any two adjacent semi-spherical protrusions is 0.15 mm, and a maximum distance between a semi-spherical protrusion and the first surface is 5 µm.

An arc edge area having a peripheral width of 5 mm of the rear cover matrix of the mobile phone is a texture gradient area. In the texture gradient area, semi-spherical protrusions are distributed in a gradient trend. From an inner circumference to an outer circumference of arc edge area, diameters of the semi-spherical protrusions gradually decrease from 0.09 mm to 0.03 mm, that is, orthographic projection areas of the semi-spherical protrusions on the first surface gradually decrease from 0.0064 mm² to 0.0007 mm², a spacing between two adjacent semi-spherical protrusions gradually increases from 0.15 mm to 0.2 mm, and a maximum distance between the semi-spherical protrusion and the first surface ranges from 3 µm to 5 µm. Certainly, in another embodiment, the width of the texture gradient area, a maximum orthographic projection area and a maximum orthographic projection area of a micro-texture unit in the texture gradient area, and a maximum spacing and a minimum spacing may also be designed as another specific value.

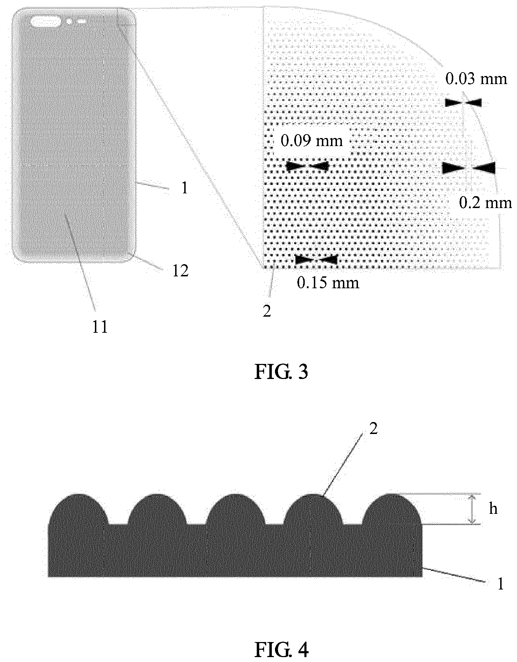

FIG. 3 is a schematic structural diagram of a rear glass cover of the mobile phone according to Embodiment 1 of the present invention. In the figure, 1 represents the rear cover matrix of the mobile phone, 2 represents a semi-spherical protrusion, 11 represents an intermediate plane area, and 12 represents an arc edge area.

FIG. 4 is a schematic diagram of a local cross section of an intermediate plane area of a rear glass cover of a mobile phone according to an embodiment of the present invention. 1 represents a rear cover matrix of the mobile phone, 2 represents a semi-spherical protrusion, and h is a height of the semi-spherical protrusion.

In this embodiment, a method for preparing the high-strength anti-fingerprint glass rear cover of the mobile phone includes the following steps:
(1) obtaining a white glass plate having a thickness of 0.51 mm, cutting the white glass plate based on a design size, performing CNC and polishing on the white glass plate, to enable the white glass plate to meet a design requirement of the rear cover of the mobile phone, to form a 2.5 D shape;
(2) coating photoresist on a surface on a side of an outer surface (a surface towards the exterior of the mobile phone) that is the white glass and that is preset as the rear cover of the mobile phone, and performing exposure and development;
(3) removing a protective film of a to-be-etched area; exposing the to-be-etched area to the outside; placing the white glass into an etching solution for etching for 2 to 10 seconds, to form a micro-texture structure; after etching is completed, taking the white glass out, removing the film, and cleaning the white glass, where the etching solution contains hydrogen fluoride with a mass content of 30%; and
(4) finally, performing anti-fingerprint coating on a surface that has a micro-texture structure to form an anti-fingerprint protective film, to obtain a 2.5D glass rear cover of the mobile phone.

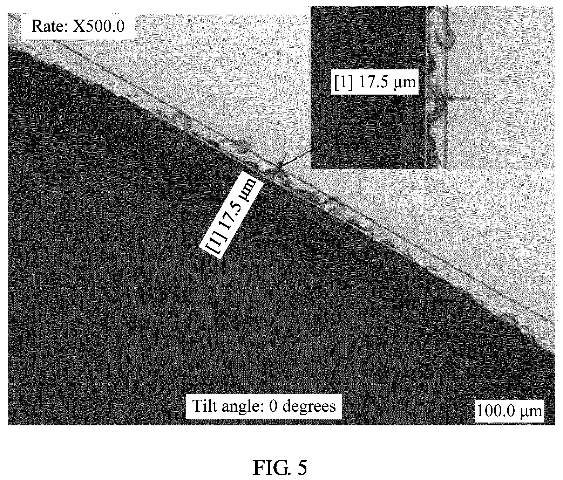

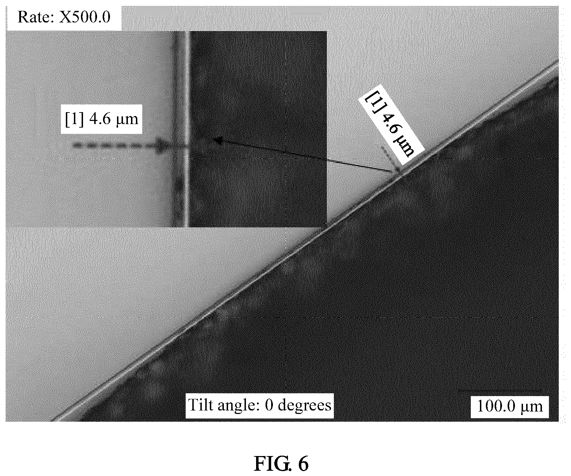

The micro-texture structure in this embodiment of the present invention changes a physical structure of the glass surface, increases roughness of the glass surface, and further changes a contact area between the glass surface and a finger, so that generation of a fingerprint and an oil stain on the glass surface can be fundamentally avoided, and user experience can be improved. A design of the micro-texture structure in this embodiment of the present invention may further improve glass strength. This is because some micro-cracks are generated after the CNC process is performed on the glass, and the photochemical etching operation in this embodiment of the present invention may eliminate these micro-cracks. FIG. 5 and FIG. 6 are separately scanning electron microscope diagrams of an arc edge of a rear glass cover of a mobile phone before and after etching according to an embodiment of the present invention. It can be learned from FIG. 5 that, before etching, there are a plurality of protruding micro-bubble structures on the arc edge of the rear glass cover of the mobile phone, and the surface is rough. After etching, these micro-bubble structures disappear, and the surface on the arc edge becomes smoother. Therefore, strength of the rear glass cover of the mobile phone increases. To further improve strength of the rear glass cover of the mobile phone in this embodiment of the present invention, a micro-texture structure may also be provided on an inner surface of the rear cover of the mobile phone (a surface towards the interior of the mobile phone).

### Embodiment 2

A high-strength anti-fingerprint glass rear cover of a mobile phone includes a rear cover matrix (2.5D glass) of the mobile phone, and the rear cover matrix of the mobile phone includes a first surface and a second surface that are provided opposite to each other. A micro-texture structure is provided on the first surface, and an anti-fingerprint protective film is further disposed. In this embodiment, the first surface is a side surface that a user can directly come into contact with and that faces the outside of the mobile phone. The micro-texture structure includes a plurality of quadrate protrusions.

In an intermediate plane area of the rear cover matrix of the mobile phone, the quadrate protrusions are arranged in arrays with a side length of 0.12 mm, an orthographic projection area on the first surface is 0.0144 mm², a spacing between any two adjacent quadrate protrusions is 0.08 mm, and a maximum distance between the quadrate protrusion and the first surface is 3 µm.

An arc edge area having a peripheral width of 5 mm of the rear cover matrix of the mobile phone is a texture gradient area. In the texture gradient area, quadrate protrusions are distributed in a gradient trend. From an inner circumference to an outer circumference of the arc edge area, side lengths of the quadrate protrusions gradually decrease from 0.12 mm to 0.02 mm, that is, orthographic projection areas of the quadrate protrusions on the first surface gradually decreases from 0.0144 mm² to 0.0004 mm², and a spacing between two adjacent quadrate protrusions gradually increases from 0.08 mm to 0.2 mm, and a maximum distance between the quadrate protrusion and the first surface is 3 µm to 5 µm. Certainly, in another embodiment, a width of the texture gradient area, a maximum orthographic projection area and a maximum orthographic projection area of a micro-texture unit in the texture gradient area, and a maximum spacing and a minimum spacing may also be designed as another specific value.

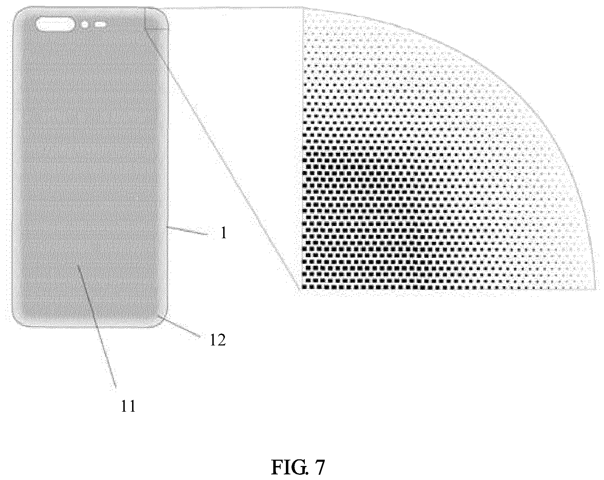

FIG. 7 is a schematic structural diagram of a rear glass cover of a mobile phone according to Embodiment 2 of the present invention. FIG. 4 is a quadrate protrusion.

### Embodiment 3

A high-strength anti-fingerprint glass rear cover of a mobile phone is provided. An only difference between the rear cover and that in Embodiment 1 is that a rear cover matrix of the mobile phone is 3D glass.

The 3D glass rear cover of the mobile phone in this embodiment may be prepared according to the following steps:
(1) obtaining a white glass plate having a thickness of 0.51 mm, cutting the white glass plate based on a design size, performing CNC and polishing on the white glass plate, to enable the white glass plate to meet a design requirement of the rear cover of the mobile phone;
(2) performing CNC cutting based on a hot bending compensation size of the glass, and performing hot bending by using a 3D glass hot bending machine, to form a 3D shape;
(3) performing double-sided polishing on glass obtained through hot bending, then coating photoresist on a surface on a side of an outer surface (a surface towards the exterior of the mobile phone) of the rear cover of the mobile phone, and performing exposure and development;
(4) removing a protective film of a to-be-etched area; exposing the to-be-etched area to the outside; placing the white glass into an etching solution for etching for 4 seconds to form a micro-texture structure; after etching is completed, taking the white glass out, removing the film, and cleaning the white glass, where the etching solution contains hydrogen fluoride with a mass content of 30%; and
(5) finally, performing an anti-fingerprint coating on a surface that has a micro-texture structure, to obtain a 3D glass rear cover of the mobile phone.

### Effect Embodiment

To provide strong support for beneficial effects that are brought by technical solutions in the embodiments of the present invention, the following performance test is specially provided as follows:
A ball falling test is performed on 10 3D glass rear covers that are of mobile phones and that are prepared in Embodiment 3 of the present invention, to learn anti-impact strength of the samples. In addition, 10 3D glass rear cover samples that are of mobile phones and that are prepared by using common hot-bent and toughened white glass (single-sided curved panda glass) that has a same thickness and on which no micro-texture structure is disposed are used as a control group. Specific test operations are as follows: Steel balls having a mass of 32.65 g and a diameter of 20 mm fall once freely on different parts of the sample from a height (9 impact points, each point is impacted once), the height starts to be gradually increased from 62.5 cm, and cracking energy is recorded. A test result is shown in Table 1. When a falling height is 62.5 cm, the corresponding impact energy is 0.2 joules. The samples of the to-be-tested 3D glass rear covers of mobile phones in this embodiment of the present invention and in the control group have a thickness of 0.51 mm, a length of 145 mm, a width of 67.66 mm, a round angle of R6.5 mm, and a total height of 4 mm.

**Table 1**

| Sample number | Anti-impact energy of samples in the control group (Joule J) | Anti-impact energy (Joule J) of samples in this embodiment of the present invention |
|---|---|---|
| 1 | 0.4 | 1.25 |
| 2 | 0.25 | 1.25 |
| 3 | 1 | 1.25 |
| 4 | 0.4 | 1.25 |
| 5 | 0.35 | 1.25 |
| 6 | 0.4 | 1.25 |
| 7 | 0.3 | 1.25 |
| 8 | 0.3 | 1.25 |
| 9 | 0.35 | 1.25 |
| 10 | 0.35 | 1.1 |
| Average value | 0.41 | 1.235 |

| | | |
|---|---|---|
| (Note: 1.25 J indicates that the equipment test limit is exceeded). | | |

It may be learned from the test result in Table 1 that, because a micro-texture structure is set on a surface of a 3D glass rear cover of a mobile phone in this embodiment of the present invention, anti-impact strength performance is greatly improved compared with a sample in the control group.

It should be noted that, according to the disclosure and descriptions of the foregoing specification, a person skilled in the art of the present invention may further change and modify the foregoing implementations. Therefore, the present invention is not limited to the specific implementations disclosed and described above, and some equivalent modifications and alterations to the present invention should also fall within the protection scope of the claims of the present invention. In addition, although some specific terms are used in this specification, these terms are merely used for convenience of description and do not constitute any limitation on the present invention.

## Claims

1. High-strength anti-fingerprint glass, comprising a glass base material, wherein the glass base material comprises a first surface and a second surface that are provided opposite to each other, at least one of the first surface and the second surface is provided with a micro-texture structure, the micro-texture structure comprises a plurality of micro-texture units, an orthographic projection area of each micro-texture unit on the first surface or the second surface ranges from 0.0004 mm² to 0.0144 mm², and a maximum distance between the micro-texture unit and the surface on which the micro-texture unit is located ranges from 2 µm to 7 µm.

2. The high-strength anti-fingerprint glass according to claim 1, wherein visible light transmittance of the high-strength anti-fingerprint glass is 95% to 100%.

3. The high-strength anti-fingerprint glass according to claim 1 or 2, wherein a spacing between any two adjacent micro-texture units is 0.02 mm to 0.2 mm.

4. The high-strength anti-fingerprint glass according to any one of claims 1 to 3, wherein the plurality of micro-texture units are regularly or irregularly arranged on the glass base material.

5. The high-strength anti-fingerprint glass according to any one of claims 1 to 4, wherein the micro-texture unit is a groove or a protrusion of a geometric or non-geometric shape.

6. The high-strength anti-fingerprint glass according to any one of claims 1 to 5, wherein the plurality of micro-texture units are of the same shapes, have the same orthographic projection areas on the first surface or the second surface, and are arranged on the glass base material in arrays.

7. The high-strength anti-fingerprint glass according to any one of claims 1 to 6, wherein a local area or all areas of the at least one of the first surface and the second surface are set as texture gradient areas.

8. The high-strength anti-fingerprint glass according to any one of claims 1 to 7, wherein a thickness of the high-strength anti-fingerprint glass is 0.5 mm to 0.7 mm, and anti-impact strength is 0.5 joules/m² to 1.25 joules/m².

9. The high-strength anti-fingerprint glass according to any one of claims 1 to 8, wherein the high-strength anti-fingerprint glass is 2D glass, 2.5D glass, or 3D glass.

10. A method for preparing high-strength anti-fingerprint glass, comprising the following steps:
obtaining a white glass raw material, wherein the white glass raw material comprises a first surface and a second surface that are provided opposite to each other; and performing etching on at least one of the first surface and the second surface of the white glass raw material by using a photochemical etching method to form a micro-texture structure, to obtain 2D high-strength anti-fingerprint glass; or
obtaining a white glass raw material; first processing the white glass raw material into a 2.5D shape; and then performing etching on at least one of a first surface and a second surface of the white glass raw material by using a photochemical etching method to form a micro-texture structure, to obtain 2.5D high-strength anti-fingerprint glass; or
obtaining a white glass raw material; first processing the white glass raw material into a 3D shape; and then performing etching on at least one of a first surface and a second surface of the white glass raw material by using a photochemical etching method, to form a micro-texture structure; or first performing etching on at least one of a first surface and a second surface of the white glass raw material by using a photochemical etching method, to form a micro-texture structure, and then processing the white glass raw material with the micro-texture structure into a 3D shape, to obtain 3D high-strength anti-fingerprint glass, wherein
the micro-texture structure comprises a plurality of micro-texture units, an orthographic projection area of each micro-texture unit on the first surface or the second surface ranges from 0.0004 mm² to 0.0144 mm², and a maximum distance between the micro-texture unit and the surface on which the micro-texture unit is located ranges from 2 µm to 7 µm.

11. The method for preparing high-strength anti-fingerprint glass according to claim 10, wherein specific operations of the photochemical etching method are as follows: cleaning a to-be-etched white glass raw material, coating the white glass raw material with a layer of photoresist after the white glass raw material is dried, exposing a to-be-etched area to the outside after exposure and development, and placing the white glass raw material into an etching solution, and after the white glass raw material is etched for 2 to 10 seconds, taking the white glass raw material out and removing a film, to obtain a micro-texture structure, wherein the etching solution comprises hydrogen fluoride and/or another weak acid substance.

12. An exterior part of high-strength anti-fingerprint glass, comprising a glass exterior part matrix and an anti-fingerprint protective film disposed on a surface of the glass exterior part matrix, wherein the glass exterior part matrix is made of the high-strength anti-fingerprint glass according to any one of claims 1 to 9.

13. The exterior part of the high-strength anti-fingerprint glass according to claim 12, wherein the glass exterior part matrix comprises a terminal housing, a terminal cover, a key, a touchscreen, meter glass, or a camera protective cover.

14. The exterior part of the high-strength anti-fingerprint glass according to claim 12 or 13, wherein the glass exterior part matrix comprises a first surface and a second surface that are provided opposite to each other; an edge area of at least one of the first surface and the second surface is set as a texture gradient area, and a width of the texture gradient area is 2 mm to 10 mm; and from an inner circumference to an outer circumference in the texture gradient area, an orthographic projection area of the micro-texture unit on the first surface or the second surface gradually decreases, and a spacing between the two adjacent micro-texture units gradually increases.

15. A method for preparing an exterior part of high-strength anti-fingerprint glass, comprising the following steps:
obtaining a white glass raw material, wherein the white glass raw material comprises a first surface and a second surface that are provided opposite to each other; cutting and performing CNC processing on the white glass raw material to meet an exterior part design requirement; then performing etching on at least one of the first surface and the second surface of the white glass raw material by using a photochemical etching method, to form a micro-texture structure; and then performing anti-fingerprint coating to obtain the exterior part of the high-strength anti-fingerprint glass, wherein a CNC process enables the glass to remain a 2D shape or to form a 2.5D shape; or
obtaining a white glass raw material; processing the white glass raw material to meet an exterior part design requirement by successively performing a cutting, CNC, hot bending, and polishing process; performing etching on at least one of a first surface and a second surface of the white glass raw material by using a photochemical etching method, to form a micro-texture structure; and then performing anti-fingerprint coating to obtain the exterior part of the high-strength anti-fingerprint glass, wherein a 3D shape is formed in the hot bending process; or
obtaining a white glass raw material; performing etching on at least one of a first surface and a second surface of the white glass raw material by using a photochemical etching method, to form a micro-texture structure; processing the white glass raw material to meet an exterior part design requirement by successively performing CNC and hot bending; and then performing anti-fingerprint coating to obtain the exterior part of the high-strength anti-fingerprint glass, wherein a 3D shape is formed in the hot bending process, wherein
the micro-texture structure comprises a plurality of micro-texture units, an orthographic projection area of each micro-texture unit on the first surface or the second surface ranges from 0.0004 mm² to 0.0144 mm², and a maximum distance between the micro-texture unit and the surface on which the micro-texture unit is located ranges from 2 µm to 7 µm.
